# EUROPÄISCHE PATENTANMELDUNG

(11) **EP 1 001 430 A2**
(43) Veröffentlichungstag der Anmeldung: **17.05.2000**
(21) Anmeldenummer: 99122593.9
(22) Anmeldetag: 12.11.1999
(51) Int. Cl.: G11C 11/22

(54) **Ferroelektrische Speicheranordnung**

(30) Priorität: 13.11.1998 DE 19852570
(71) Anmelder: Infineon Technologies AG, 81541 München (DE)
(72) Erfinder: Rohr, Thomas, Dr., 82178 Puchheim (DE); Hönigschmid, Heinz, 82319 Starnberg (DE); Braun, Georg, 80339 München (DE)
(74) Vertreter: Zedlitz, Peter, Dipl.-Inf.

(57) **Zusammenfassung**

Die Erfindung betrifft eine Speicheranordnung aus einer Anzahl von Speicherzellen, die jeweils wenigstens einen ferroelektrischen Speicherkondensator (Cferro) und einen Auswahltransistor (TG) aufweisen und über Wortleitungen (WL) und Bitleitungspaare (BL <0>, bBL <0>; BL <1>, bBL <1>) angesteuert sind, wobei in einem Leseverstärker (SA <01>) ein über ein Bitleitungspaar aus einem Referenzzellenpaar (R) gewonnenes Referenzsignal mit einem Lesesignal aus einer Speicherzelle (L) vergleichbar ist. Dem Leseverstärker (SA <01>) sind dabei zwei Bitleitungspaare zugeordnet, die so geschaltet sind, daß über das erste Bitleitungspaar das Referenzsignal und gleichzeitig über das zweite Bitleitungspaar das Lesesignal an den Leseverstärker (SA <01>) angelegt ist.

## Beschreibung

Die vorliegende Erfindung betrifft eine Speicheranordnung aus einer Vielzahl von Speicherzellen, die jeweils wenigstens einen ferroelektrischen Speicherkondensator und einen Auswahltransistor aufweisen und über Wortleitungen und Bitleitungspaare angesteuert sind, wobei in einem Leseverstärker ein über ein Bitleitungspaar aus einer Referenzzelle gewonnenes Referenzsignal mit einem Lesesignal aus einer Speicherzelle vergleichbar ist.

Bekanntlich können mit ferroelektrischen Dielektrika aus beispielsweise Wismutbariumtantalat (SBT) oder Bleizirkoniumtitanat (PZT) nichtflüchtige Speicheranordnungen aufgebaut werden. Bei solchen Speicheranordnungen können einzelne Speicherzellen aus jeweils einem Auswahltransistor und einem Speicherkondensator mit einem Dielektrikum aus SBT oder PZT bestehen, so daß ein sogenanntes "1T/1C-Zellenkonzept" vorliegt. Mit diesem 1T/1C-Zellenkonzept können grundsätzlich ähnliche Speicherdichten wie bei herkömmlichen DRAMs (dynamische Schreib/Lesespeicher) erreicht werden.

Beim Lesen einer Speicherzelle mit einem ferroelektrischen Speicherkondensator, einer sogenannten FeRAM-Speicherzelle, muß vor dem Lesen der eigentlichen Information aus der Speicherzelle zunächst eine Referenzspannung erzeugt werden, was durch das Auslesen eines Referenz-Speicherzellenpaares geschehen kann. Erst nach Gewinnung der Referenzspannung aus dem Referenz-Speicherzellenpaar wird dann die eigentliche Speicherzelle ausgelesen, und das aus dieser Speicherzelle erhaltene Lesesignal wird mit der zuvor erzeugten Referenzspannung im Leseverstärker verglichen und ausgewertet.

Ein solcher, notwendigerweise "serieller" Lesezyklus benötigt relativ viel Zeit, da die Referenzspannung und das eigentliche Lesesignal zeitlich nacheinander generiert werden. Bisher gibt es keine Überlegungen, wie diese relativ lange Zeitdauer möglicherweise verkürzt werden könnte.

Dies ist im wesentlichen wohl darauf zurückzuführen, daß bisher beim Lesen einer Speicheranordnung aus FeRAM-Speicherzellen, also einer ferroelektrischen Speicheranordnung, ein ähnliches Verfahren wie beim Lesen eines DRAM angewandt wird: die zu lesende Speicherzelle mit einem ein ferroelektrisches Dielektrikum aus beispielsweise SBT oder PZT aufweisenden Speicherkondensator wird mittels des Auswahltransistors der Speicherzelle mit einer Bitleitung verbunden. Aufgrund der Verhältnisse der Kapazitäten ergibt sich auf der Bitleitung dann ein Nutzsignal in der Größenordnung von einigen 100 mV. Dieses relativ kleine Nutzsignal wird in dem Leseverstärker auf den vollen Logikpegel verstärkt. Hierzu benötigt der Leseverstärker aber eine Referenzspannung, die in bevorzugter Weise der Mittelwert der Spannungen darstellen sollte, die jeweils beim Auslesen einer logischen Null (0) bzw. einer logischen Eins (1) aus einer Speicherzelle erhalten wird. Die Referenzspannung kann generiert werden, indem auf einem Bitleitungspaar zwei Referenzzellen ausgelesen werden, die inverse Informationen, also "Null" und "Eins" enthalten müssten. Durch anschließendes Kurzschließen des Bitleitungspaares wird der arithmetische Mittelwert der beiden zuvor erhaltenen Lesesignale gewonnen. Das so erzeugte Referenzsignal mit dem Mittelwert wird auf einer der beiden Bitleitungen belassen, während sodann auf der anderen Bitleitung die auszulesende Speicherzelle aktiviert wird. Im Leseverstärker wird dann die ausgelesene Spannung mit der Referenzspannung verglichen und schließlich auf den vollen Logikpegel verstärkt.

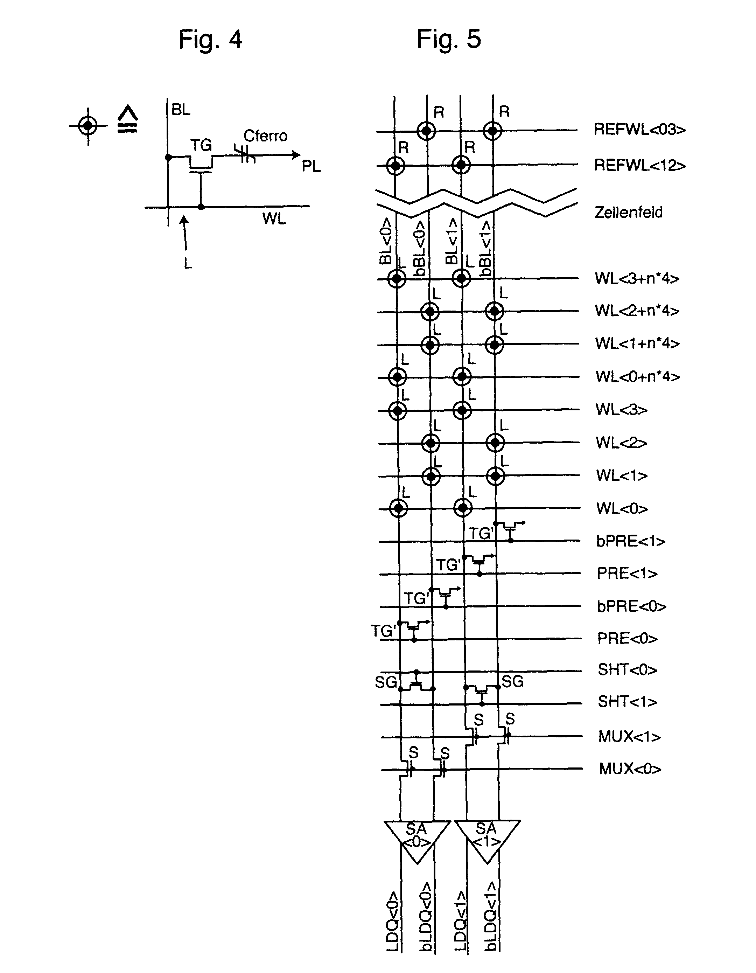

Im folgenden wird anhand der Fig. 4 bis 6 das Leseverstärkerkonzept bei einer bestehenden ferroelektrischen Speicheranordnung mit dem herkömmlichen seriellen Zugriffszyklus erläutert. Fig. 4 zeigt eine Speicherzelle aus einem ferroelektrischen Speicherkondensator Cferro und einem Auswahltransistor TG, wobei Source bzw. Drain des Auswahltransistors TG an eine Bitleitung BL angeschlossen ist und Gate des Auswahltransistors TG an einer Wortleitung WL liegt. Der ferroelektrische Speicherkondensator Cferro liegt zwischen Source bzw. Drain des Auswahltransistors TG und einer gemeinsamen Plattenspannung PL.

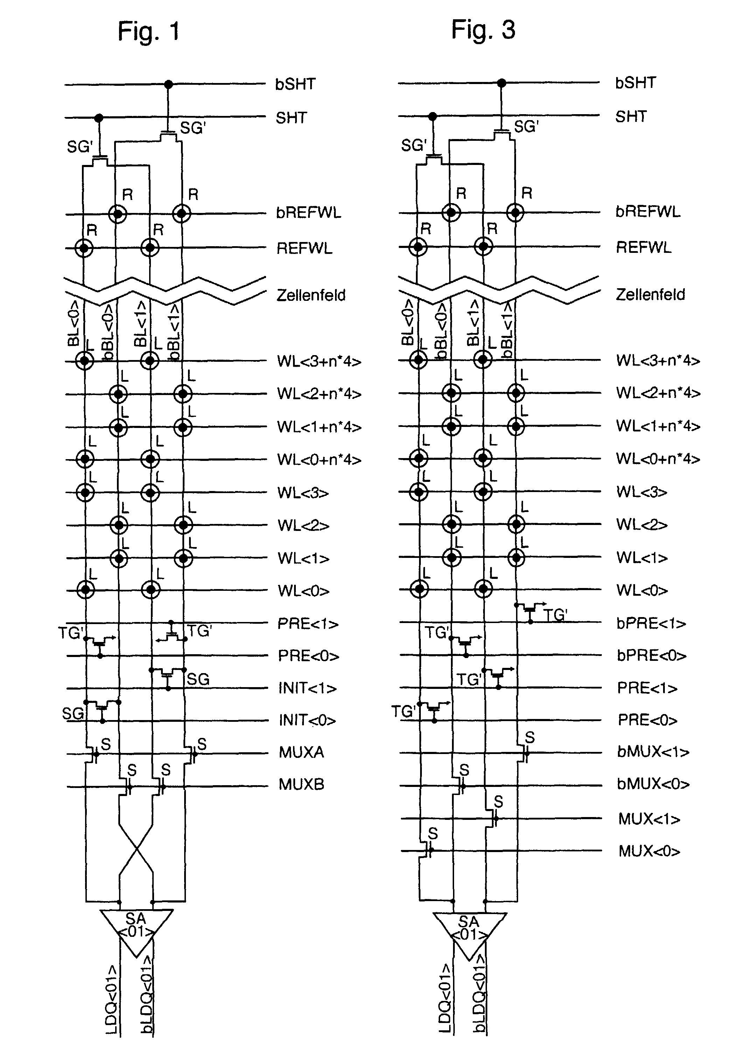

In den Fig. 1, 3 und 5 ist eine derartige Speicherzelle durch das in Fig. 4 angegebene Symbol wiedergegeben.

Fig. 5 zeigt den Schaltungsaufbau einer herkömmlichen Speicheranordnung mit dem üblichen Leseverstärkerkonzept für einen seriellen Zugriffszyklus. Bei dieser herkömmlichen Speicheranordnung sind Bitleitungspaare BL <0> und bBL <0> bzw. BL <1> und bBL <1> über Auswahltransistoren S mit jeweils einem Leseverstärker SA <0> bzw. SA <1> verbunden. Wesentlich ist, daß bei dieser bestehenden Speicheranordnung Referenzzellen R und zu lesende Zellen L jeweils elektrisch mit demselben Bitleitungspaar BL <0> und bBL <0> bzw. BL <1> und bBL <1> verbunden sind. Hierdurch ist lediglich ein sequentielles Erzeugen der Referenzspannung mittels der Referenzzellen R und ein anschließendes Auslesen der Speicherzellen L möglich.

Dieses sequentielle Erzeugen der Referenzspannung und anschließende Auslesen der Speicherzelle soll im folgenden anhand der Fig. 6 näher erläutert werden.

Ein Lesezyklus beginnt beispielsweise bei t = 10 ns mit einer negativen Flanke eines Abtast- bzw. Strobe-Signales. Es schließt sich sodann die Generierung einer Referenzspannung ref in einem Zeitraum A an. Hierzu werden zunächst beispielsweise die beiden Bitleitungen BL <0> und bBL <0> auf 0 Volt entladen (Vorgang "pre" in Fig. 6). Anschließend werden zwei Referenzzellen R an den Schnittstellen zwischen Referenzwortleitungen REFWL <03> und REFWL <12> mit den Bitleitungen BL <0> und bBL <0> mit inverser Information ausgelesen, was ein Signal "ref" ergibt. Schließlich wird durch Kurzschließen der beiden Bitleitungen BL <0> und bBL <0> mittels eines Kurzschlußtransistors SG, der über eine Kurzschlußleitung SHT <0> (bzw. SHT <1>) angesteuert ist, der arithmetische Mittelwert der Referenzspannungen der Referenzzellen R gebildet (vgl. Zeitraum "short" in Fig. 6).

In einem folgenden Zeitraum B wird sodann die zu lesende Bitleitung, also beispielsweise die Bitleitung BL <0> auf 0 Volt entladen (vgl. Zeitraum "prerd" in Fig. 6), und dann wird die Speicherzelle ausgelesen (vgl. Zeitraum "read" in Fig. 6).

Nun liegt an der zu lesenden Bitleitung BL <0> eine Spannung an, die je nach Speicherinhalt der zu lesenden Speicherzelle L kleiner oder größer als die Referenzspannung ist. Im nachfolgenden Verstärkungsvorgang während einer Zeitdauer C wird diese kleine Spannung auf einen vollen Logikpegel verstärkt (Zeitraum "sense").

Etwa bei t = 70 ns, also etwa 60 ns nach Beginn des Lesezyklus, steht so die gelesene Information auf Datenleitungen LDQ <0> und bLDQ <0> zur weiteren Verarbeitung bereit. Abschließend erfolgen noch das Zurückschreiben der Information in die Referenzzellen R (Zeitraum "write back") und das Zurückführen in den Ruhezustand während eines Zeitraumes D.

Fig. 5 zeigt zusätzlich Schalttransistoren S, die über Steuerleitungen MUX <0> und MUX <1> ansteuerbar sind und die einzelnen Bitleitungen BL <0>, bBL <0>, BL <1> und bBL <1> mit den Leseverstärkern SA <0> bzw. SA <1> verbinden. Die Speicherzellen L liegen jeweils an Schnittstellungen der Bitleitungen BL <0>, bBL <0>, BL <1> und bBL <1> mit Wortleitungen WL <0>, WL <1>, WL <2>, WL <3>, ... WL <0+n*4>, WL <1+n*4>, WL <2+n*4> und WL <3+n*4>. Die Speicherzellen L bilden dabei ein Zellenfeld, wie dieses schematisch in Fig. 5 veranschaulicht ist.

Es ist Aufgabe der vorliegenden Erfindung, eine Speicheranordnung zu schaffen, bei der ein Lesezyklus in seiner Zeitdauer wesentlich vermindert werden kann.

Diese Aufgabe wird bei einer Speicheranordnung der eingangs genannten Art erfindungsgemäß dadurch gelöst, daß dem Leseverstärker zwei Bitleitungspaare zugeordnet sind, die so geschaltet sind, daß über das erste Bitleitungspaar das Referenzsignal und gleichzeitig über das zweite Bitleitungspaar das Lesesignal an den Leseverstärker angelegt sind.

Bei der erfindungsgemäßen Speicheranordnung wird so durch eine relativ geringfügige schaltungstechnische Änderung des bestehenden Konzeptes eine Verkürzung des Lesezugriffes auf eine Speicherzelle um etwa 30 % erreicht, was weiter unten noch näher erläutert werden wird. Die Änderung besteht im Prinzip darin, daß mittels Kurzschlußbauelementen, also der oben genannten Transistoren SG, nicht mehr benachbarte, sondern die jeweils übernächste Bitleitung miteinander verbunden sind, so daß also diese Kurzschlußbauelemente die jeweils übernächste Bitleitung miteinander verbinden. Diese Kurzschlußbauelemente können in bevorzugter Weise an dem im Leseverstärker gegenüberliegenden Ende des Zellenfeldes angeordnet werden, da hier die Überkreuzung von benachbarten Bitleitungen im Schaltungs-Layout leichter zu realisieren ist. Durch die parallele Anordnung der benutzten Bitleitungspaare liegen die jeweils aktive Speicherzelle und die Referenzzellen relativ dicht nebeneinander im gleichen Block des Speicherzellenfeldes, das sich positiv auf die Störsicherheit auswirkt. Das Lesesignal und das Referenzsignal werden über die Auswahltransistoren S an die Eingänge des jeweiligen Leseverstärkers geschaltet. Gleichzeitig wird durch die Verwendung dieser Auswahltransistoren die Anzahl der benötigen Leseverstärker und damit auch die für die Leseverstärker benötigte Halbleiterchipfläche halbiert.

In einer bevorzugten Weiterbildung der Erfindung ist vorgesehen, daß die Bitleitungen jedes Bitleitungspaares durch Initialisierungstransistoren miteinander verbunden sind. Bei diesem Ausführungsbeispiel werden zwei Steuerleitungen nicht mehr zum Vorladen, sondern zum Kurzschließen der beiden Bitleitungen verwendet.

Gemäß einem anderen Ausführungsbeispiel der vorliegenden Erfindung ist vorgesehen, daß jede Bitleitung mit einem gesondert ansteuerbaren Bitleitungs-Auswahltransistor versehen ist. Damit ist es möglich, die Bitleitungs-Auswahltransistoren eines Bitleitungspaares alle einzeln anzusteuern, wobei das Kurzschlußbauelement nicht mehr benachbarte, sondern jeweils übernächste Bitleitungen miteinander verbindet.

Nachfolgend wird die Erfindung anhand der Zeichnungen näher erläutert. Es zeigen:
- Fig. 1: ein Schaltbild eines ersten Ausführungsbeispiels der vorliegenden Erfindung,
- Fig. 2: den zeitlichen Verlauf eines Lesevorganges bei dem Ausführungsbeispiel von Fig. 1,
- Fig. 3: ein Schaltbild eines zweiten Ausführungsbeispiels der vorliegenden Erfindung,
- Fig. 4: ein schematisches Schaltbild einer Speicherzelle,
- Fig. 5: ein Schaltbild einer herkömmlichen Speicheranordnung und
- Fig. 6: den Verlauf eines Lesevorganges bei der Speicheranordnung von Fig. 5.

Die Fig. 4 bis 6 sind bereits eingangs erläutert worden. In den Fig. 1 bis 3 werden für einander entsprechende Bauteile die gleichen Bezugszeichen wie in den Fig. 4 bis 6 verwendet. Auch werden diese Bauteile nicht mehr gesondert beschrieben.

Fig. 1 zeigt ein Ausführungsbeispiel der erfindungsgemäßen Speicheranordnung, bei dem im Unterschied zu der bestehenden Speicheranordnung gemäß Fig. 5 Kurzschlußbauelemente SG' in der Form von Feldeffekttransistoren nicht mehr benachbarte, sondern jeweils übernächste Bitleitungen miteinander verbinden, wie dies für die Bitleitungen BL <0> und BL<1> bzw. bBL <0> und bBL <1> gezeigt ist. Auch werden hier zwei Steuerleitungen INIT <0> und INIT <1> nicht mehr zum Vorladen, sondern zum Kurzschließen zweier Bitleitungen BL <0> und bBL <0> bzw. BL <1> und bBL <1> verwendet. In bevorzugter Weise sind die Kurzschlußbauelemente SG', die die jeweils übernächste Bitleitung miteinander verbinden, an dem dem Leseverstärker SA gegenüberliegenden Ende des Zellenfeldes angeordnet, da hier die Überkreuzung der benachbarten Bitleitungen im Schaltungs-Layout leichter realisiert werden kann. Durch die parallele Anordnung der benutzten Bitleitungspaare liegen die jeweils aktive Speicherzelle L und die Referenzzellen R relativ dicht beieinander, was sich positiv auf die Störsicherheit auswirkt. Das Lesesignal und das Referenzsignal werden über die Auswahltransistoren S an die Eingänge des Leseverstärkers SA <01> geschaltet. Gleichzeitig wird durch die Verwendung dieser Auswahltransistoren S die Anzahl der benötigten Leseverstärker SA und damit auch die für die Leseverstärker benötigte Halbleiterchipfläche halbiert.

Durch die Speicheranordnung gemäß der Fig. 1 kann ein erheblich verkürzter Lesezugriff erreicht werden. Der gemeinsame Leseverstärker SA <01> ist nämlich über die vier Auswahltransistoren S, die an Steuerleitungen MUXA bzw. MUXB angeschlossen sind, mit den beiden Bitleitungspaaren BL <0> bzw. bBL <0> und BL <1> bzw. bBL <1> verbunden. Sollten beispielsweise die Speicherzelle L an der Kreuzung der Wortleitung <0> mit der Bitleitung BL <0> ausgelesen werden, so werden zur Gewinnung des Referenzsignales die Referenzzellen R an den Kreuzungen der Wortleitung bREFWL mit der Bitleitung bBL <0> und der Wortleitung bREFWL mit der Bitleitung bBL <1> verwendet. Das Entladen ("precharge") der zu lesenden Bitleitung erfolgt über ein Signal auf der Leitung PRE <0>, und das Entladen der Referenz-Bitleitungen wird über Signale auf den Leitungen PRE <0>, PRE <1> und INIT <0> vorgenommen. Das Signal auf der Leitung INIT <1> bleibt dabei jedoch inaktiv.

Wird umgekehrt die Speicherzelle L an der Kreuzung der Wortleitung WL <0> mit der Bitleitung BL <1> ausgelesen, so erfolgt das Entladen der zu lesenden Bitleitung über das Signal auf der Leitung PRE <1> und der Leitung INIT <1>, während das Entladen der Referenz-Bitleitungen über die Signale auf den Leitungen PRE <1> und bSHT vorgenommen wird. Mit anderen Worten, in diesem Fall wird das Kurzschlußbauelement SG' an der Kurzschlußleitung bSHT auch zum Entladen der Referenz-Bitleitungen verwendet, wodurch sich zusätzliche Steuerleitungen einsparen lassen.

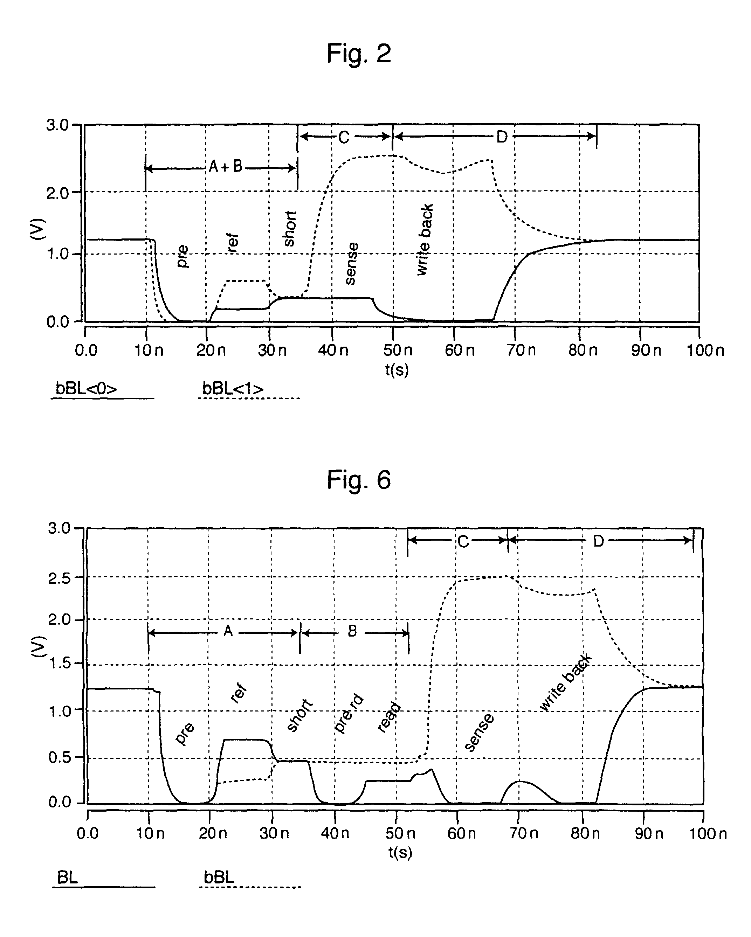

Fig. 2 zeigt ähnlich wie Fig. 6 den Signalverlauf für einen entsprechenden Lesezyklus für das Ausführungsbeispiel von Fig. 1. Der Lesevorgang beginnt wieder zu einem Zeitpunkt t = 10 ns, mit der negativen Flanke eines STB-Signales. Die Generierung der Referenzspannung (Zeitraum A in Fig. 6) und das Auslesen der Speicherzelle (Zeitraum B in Fig. 6) werden gleichzeitig und auf elektrisch nicht verbundenen Bitleitungspaaren gestartet. Die Bitleitungen bBL <0> und bBL <1> werden auf 0 Volt entladen (Zeitraum "pre"), anschließend werden die beiden Referenz-Speicherzellen R mit inverser Information ausgelesen (Zeitraum "ref"), und schließlich wird durch Kurzschließen der beiden Bitleitungen mittels des Kurzschlußelementes SG' über die Kurzschlußleitung bSHT der arithmetische Mittelwert gebildet (Zeitraum "short").

Gleichzeitig wird die zu lesende Bitleitung BL <0> auf 0 Volt entladen (Zeitraum "prered"), und dann wird die Speicherzelle L ausgelesen (Zeitraum "read"). Sodann wird durch zwei Schalttransistoren S mittels der Leitung MUXA das Lesesignal auf die Bitleitung BL <0> geschaltet, während das Referenzsignal auf die Bitleitung bBL <1> zu dem Leseverstärker SA <01> gegeben wird. Der Leseverstärker SA <01> verstärkt das Differenzsignal in dem Zeitraum C ("sense" in Fig. 2). Etwa zu einem Zeitpunkt t = 50 ns, also 40 ns nach Beginn des Lesezyklus, steht die gelesene Information auf den Datenleitungen LDQ <01> und bLDQ <01> zur weiteren Verarbeitung bereit. Abschließend folgt noch das Zurückschreiben der Information in die Referenz-Speicherzellen R (vgl. Zeitraum "write back") und das Zurückführen in den Ruhezustand (vgl. Zeitraum D in Fig. 2).

Durch das parallelisierte Leseverfahren wird so die Zeit zum Bereitstellen der gültigen Daten von etwa 60 ns auf etwa 40 ns vermindert, wobei die Verringerung der Zugriffszeit genau der Zeit für das Vorladen der zu lesenden Bitleitung ("prered") und das Auslesen der Speicherzelle ("read") entspricht.

Diese Verminderung der Zugriffszeit ist durch einen Vergleich der Fig. 2 und 6 sofort zu ersehen: im Vergleich mit der Fig. 6 wird bei der erfindungsgemäßen Speicheranordnung der Zeitraum "B" eingespart, was eine erhebliche Verminderung der Auslesezeit für die Speicheranordnung bedeutet. Der zusätzliche Schaltungsaufwand, der für diese Verminderung der Lesezeit benötigt wird, ist praktisch vernachlässigbar, was sofort durch Vergleichen des Ausführungsbeispiels der Fig. 1 mit der bestehenden Speicheranordnung von Fig. 5 zu ersehen ist. Dabei ist insbesondere auch zu beachten, daß bei der erfindungsgemäßen Speicheranordnung die Anzahl der Leseverstärker halbiert werden kann, was den zusätzlichen Aufwand an weiteren Schalttransistoren ohne weiteres ausgleicht.

Fig. 3 zeigt ein weiteres Ausführungsbeispiel der erfindungsgemäßen Speicheranordnung, bei dem die Schalttransistoren S der Bitleitungs-Doppelpaare BL <0>, bBL <0> bzw. BL <1>, bBL <1> alle einzeln angesteuert sind und die Kurzschlußbauelemente SG' an den Kurzschlußleitungen SHT bzw. bSHT nicht mehr benachbarte (vgl. Fig. 5), sondern die übernächsten Bitleitungen miteinander verbinden, wie dies auch im Ausführungsbeispiel von Fig. 1 der Fall ist. Auch beim Ausführungsbeispiel der Fig. 3 ist wie beim Ausführungsbeispiel der Fig. 1 der gemeinsame Leseverstärker SA <01> über die vier Schalttransistoren S, die mit Steuerleitungen MUX <0>, bMUX <0>, MUX <1>, bMUX <1> angesteuert sind, an die beiden Bitleitungspaare BL <0>, bBL <0> bzw. BL <1>, bBL <1> angeschlossen.

Soll nun beispielsweise die Speicherzelle L an der Kreuzung der Wortleitung WL <0> mit der Bitleitung BL <0> ausgelesen werden, so erfolgt dies in ähnlicher Weise, wie dies oben anhand der Fig. 2 für das Ausführungsbeispiel von Fig. 1 erläutert wurde.

Auch mit dem Ausführungsbeispiel der Fig. 3 kann so eine Reduzierung des Lesezyklus auf etwa 40 ns erreicht werden, was einen Zeitgewinn gegenüber dem Stand der Technik (vgl. Fig. 5) von etwa einem Drittel bedeutet.

## Patentansprüche

1. Speicheranordnung aus einer Vielzahl von Speicherzellen (L), die jeweils wenigstens einen ferroelektrischen Speicherkondensator (Cferro) und einen Auswahltransistor (TG) aufweisen und über Wortleitungen (WL <0>, WL <1>, ...) und Bitleitungspaare (BL <0>, bBL <0>, BL <1>, bBL <1>9 angesteuert sind, wobei in einem Leseverstärker (SA <1>) ein über ein Bitleitungspaar aus einem Referenzzellenpaar (R) gewonnenes Referenzsignal mit einem Lesesignal vergleichbar ist,
**dadurch gekennzeichnet**, daß
dem Leseverstärker (SA <1>) zwei Bitleitungspaare (BL <0>, bBL <0>; BL <1>, bBL <1>) zugeordnet sind, und daß jeweils ein Kurzschlußbauelement (SG') eine Bitleitung des einen Bitleitungspaares mit einer Bitleitung des anderen Bitleitungspaares verbindet, so daß über das eine Bitleitungspaar (BL <0>, bBL <0>) das Referenzsignal und gleichzeitig über das andere Bitleitungspaare (BL <1>, bBL <1>) das Lesesignal an den Leseverstärker (SA <01) angelegt ist.

2. Speicheranordnung nach Anspruch 1,
**dadurch gekennzeichnet**, daß
das Kurzschlußelement (SG') an dem zum Leseverstärker (SA <01>) entgegengesetzten Ende der Bitleitungen (BL <0>, bBL <0>, BL <1>, bBL <1>) angeordnet ist.

3. Speicheranordnung nach Anspruch 1 oder 2,
**dadurch gekennzeichnet**, daß
von zwei benachbarten Bitleitungspaaren (BL <0>, bBL <0>; BL <1<; bBL <1>) jeweils eine Bitleitung des einen Bitleitungspaares zusammen mit einer Bitleitung eines anderen Bitleitungspaares dem Leseverstärker zugeführt ist.

4. Speicheranordnung nach Anspruch 3,
**dadurch gekennzeichnet**, daß
die Bitleitungen jedes Bitleitungspaares durch Initialisierungstransistoren (SG) miteinander verbunden sind.

5. Speicheranordnung nach einem der Ansprüche 1 bis 4,
**dadurch gekennzeichnet**, daß
in jeder Bitleitung ein gesondert ansteuerbarer Bitleitungs-Schalttransistor
